# EUROPEAN PATENT APPLICATION

(11) **EP 1 970 996 A2**
(43) Date of publication of application: **17.09.2008**
(21) Application number: 08001360.0
(22) Date of filing: 24.01.2008
(51) Int. Cl.: H01R 9/00, H01R 13/66

(54) **Electric connector for connecting a power supply board to a circuit board**

(30) Priority: 16.03.2007 TW 96204266 U
(71) Applicant: Portwell Inc., Neihu Taipei City 114 (TW)
(72) Inventor: Chi, Pei-Chin, Neihu District, 114 Taipei City (TW)
(74) Representative: Volpert, Marcus

(57) **Abstract**

A micro power supply device is inserted into slots (31) of a circuit board (30), and the circuit board is fixed into an electronic system. The device includes an electric connector (10) and a plurality of neatly and oppositely arranged pins (11) on a side of the electric connector, and the pins are sheathed with conducting plates (12), and the conducting plates are electrically connected with the slots. Another end of the conducting plates is protruded from another side of the electric connector, and a power supply board (20) is inserted between the protruded conducting plates. The power supply board is connected with the power of an external port and other electronic equipments. The thickness of the power supply board is reduced, such that the conducting plates are centralized from both lateral side to the middle to reduce the volume of the whole electric connector, so as to reduce the volume of the whole device.

## Description

### BACKGROUND OF THE INVENTION

### Field of the Invention

The present invention relates to a micro power supply device, and more particularly to a power supply device that centralizes all circuits on a circuit board by using a fine circuit layout to greatly reduce the volume of the power supply device.

### Description of the Related Art

As science and technology advances, electronic technology is well developed accordingly, and electronic products become an indispensable part of our life. Each electronic product tends to be short, small, light and thin and comes with diversified functions, and the electronic product with the short, small, light and thin design must have densely installed electronic components to reduce their occupying space.

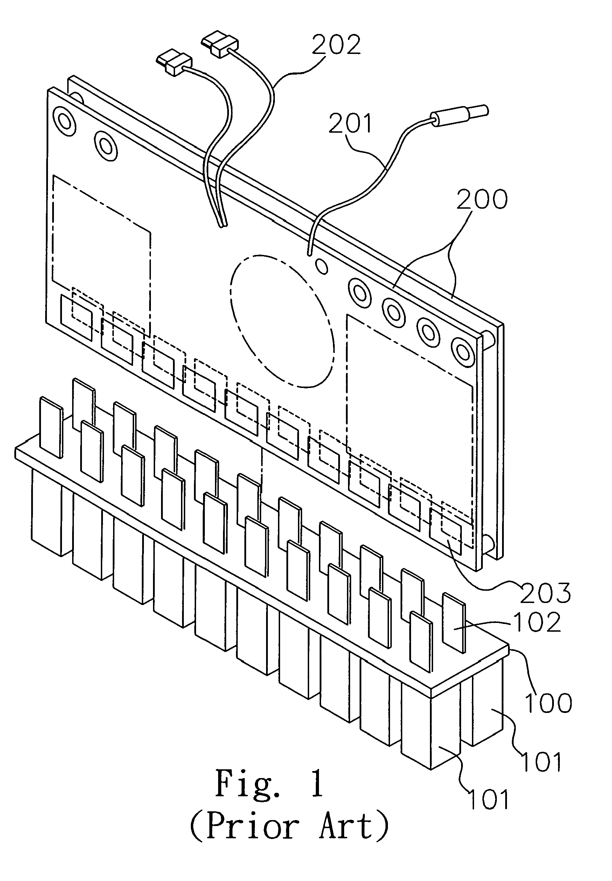

Referring to FIG 1 for a traditional micro power supply device, the device includes an electric connector 100, two rows of corresponding pins 101 disposed on a side of the electric connector 100 and inserted into slots (not shown in the figure) of the circuit board, and a conducting plate 102 disposed on both laterals of another side of the electric connector 100 and sheathed into each pin 101, wherein the conducting plates 102 is in a protruding form, and a power supply board 200 is inserted between the conducting plates 102, and the power supply board 200 is formed by connecting two circuit boards. Each circuit board has a plurality of electronic parts, a power-in connector 201 and a plurality of power-out connectors 202, wherein the power-in connector 201 can be connected to an external DC power, and the power-out connectors 202 are connected to other electronic equipments (such as an optical disk, a hard disk or any device that requires a power of 3.3V or 5V) for supplying the required power. Further, the conductive contact points 203 (commonly known as goldfingers) are disposed on a surface of the circuit board and at an end in contact with the conducting plate 102, such that the conducting plate 102 is connected with the conductive contact points 203 to constitute an electric conduction with the power supply.

Since the power supply board 200 is formed by stacking two circuit boards in parallel with each other, the volume is increased, and the distance between the conducting plates 102 of the electric connector 100 must be increased accordingly, and the power supply board 200 is installed on both lateral sides of the electric connector 100. Such arrangement not only causes a poor contact easily, but also results in a tremendous difficulty of reducing the volume of the whole device.

### Summary of the Invention

It is a primary objective of the present invention to overcome the foregoing shortcomings of the prior art by providing a micro power supply device inserted into slots of a circuit board, and the circuit board is fixed into an electronic system, and the device comprises a power supply board and an electric connector; wherein the power supply board includes a power-in connector, a power-out connector, an electronic part and a conductive contact point (commonly known as a goldfinger), and the power-in connector is connected with a DC power of an external port, and the power-out connector is connected with other electronic equipments for supplying the required DC power, and the electronic part is provided operating the circuit of the power supply board, and an end of the conductive contact point is connected with the electronic part, and another end of the conductive contact point is protruded from a surface of the power supply board; wherein a plurality of neatly and oppositely arranged protruding conducting plates are disposed on a side of the electric connector, and the positions and quantity of the conducting plates correspond to those of the conductive contact points. The conducting plates are installed at positions proximate to the middle, and the distance between the conducting plates is provided for precisely inserting conductive contact points, wherein the conducting plates are in a close contact with the conductive contact points, and the power supply board is integrated with the electric connector. Another side of the electric connector has a plurality of pins, and each pin is provided for sheathing onto another end of the conducting plate, and the pins can be inserted into the slots of the circuit board to constitute an electric connection and supply the required power to the circuit board. Compared with the prior art, the thickness of the power supply board can be reduced, and the invention not only centralizes the conducting plates from both lateral sides towards the middle to reduce the volume of the whole electric connector and results in a smaller volume of the whole device, but also reduces or eliminates the occurrence of a poor contact.

Another objective of the present invention is to provide a micro power supply device having an inputted DC power of 6V~48V.

A further objective of the present invention is to provide a micro power supply device having an outputted DC power of 3.3, 5, +12V or 5VSB (5V power standby).

Another further objective of the present invention is to provide a micro power supply device, and the exterior of the power supply board is encapsulated with a plastic substance (such as silicone and plastic) and integrated with the electric connector to provide a simple and neat appearance of the power supply device.

To make it easier for the examiner to understand the object, shape, structure, device, characteristics and functions of this invention, the specification accompanied by the drawings is described as follows.

### BRIEF DESCRIPTION OF THE DRAWINGS

FIG 1 is a schematic view of a prior art device;
FIG. 2 is an exploded view of the invention;
FIG 3 is a perspective view of the invention;
FIG 4 is a front view of an assembly of the invention;
FIG 4A is a cross-sectional side view of an assembly of the invention;
FIG 5 is a perspective view of a preferred embodiment of the invention; and
FIG 6 is a perspective view of enclosing a plastic substance around a power supply board in accordance with a preferred embodiment of the invention.

### DETAILED DESCRIPTION OF THE PREFERRED EMBODIMENTS

The present invention relates to a micro power supply device inserted into slots 31 of a circuit board 30, and the circuit board 30 is fixed into an electronic system.

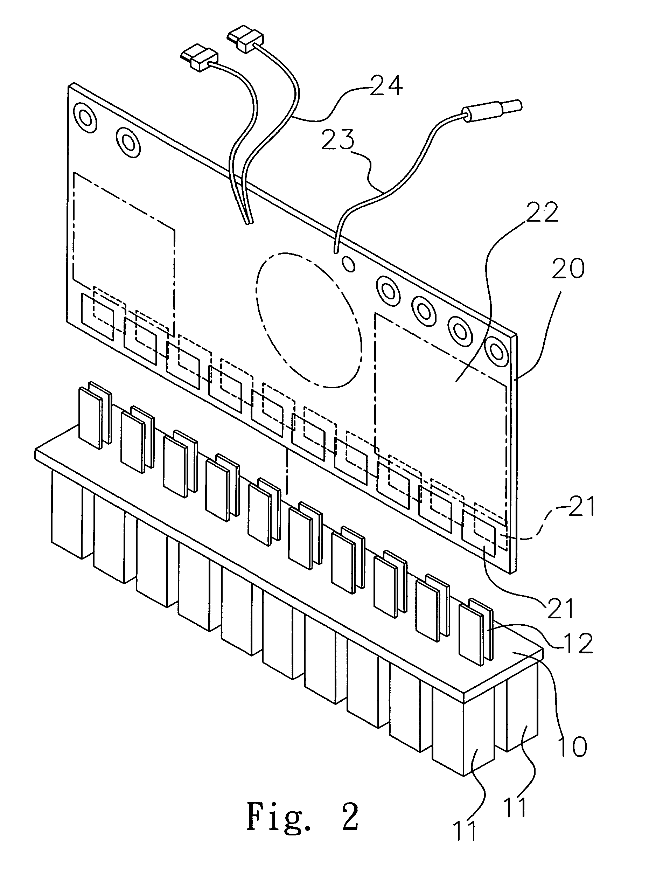

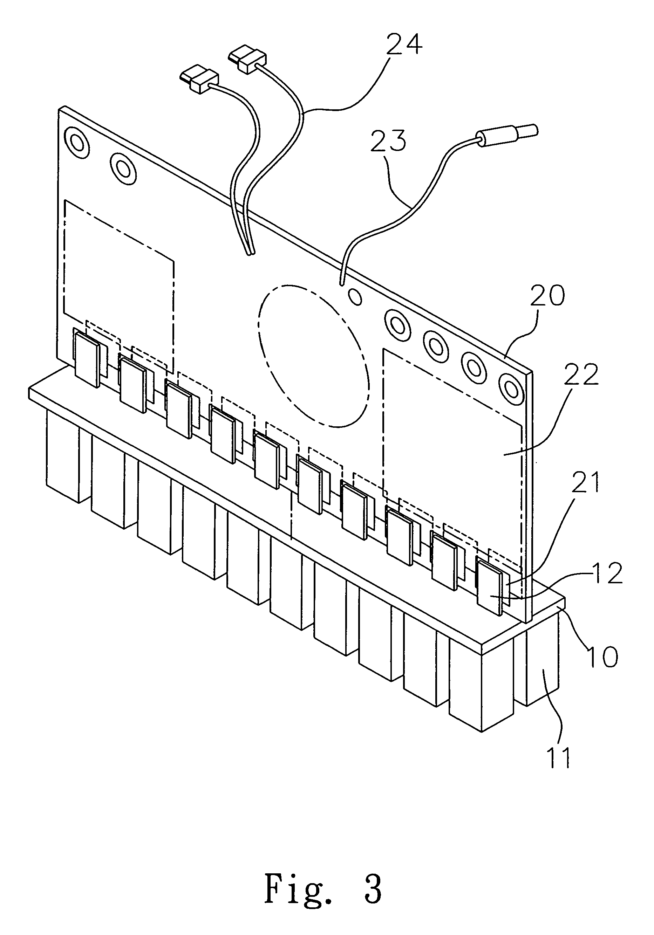

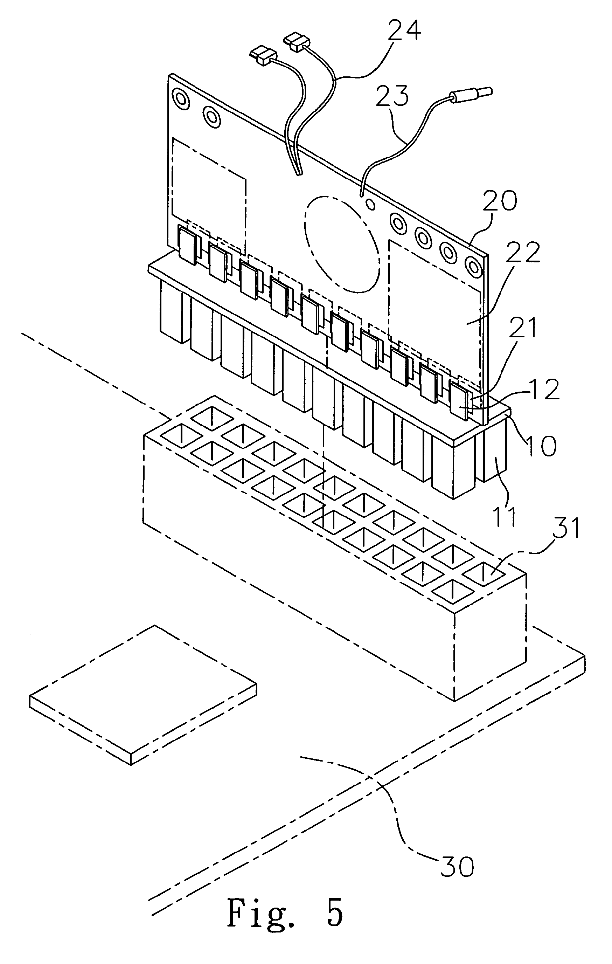

Referring to Figs. 2 to 5, the device comprises an electric connector 10, a plurality of pins arranged in two rows 11 and disposed on a side of the electric connector 10, wherein a predetermined distance is maintained between the pins 11, and the pins 11 are sheathed with conducting plates 12, and inserted into the slots 31 of a circuit board 30 on an electronic system (as shown in FIG. 5) to constitute an electric connection.

Further, another end of the conducting plate 12 is protruded from another side of the electric connector 10, and the conducting plate 12 is installed at a position proximate to the middle of the electric connector 10, and a predetermined gap is disposed between the opposite and protruding conducting plates 12. A power supply board 20 is inserted into the gap, and the power supply board 20 of this preferred embodiment is a circuit board, and the power supply board 20 has a conductive contact point 21 (commonly known as a goldfinger) on a surface in contact with an end of the conducting plate 12. The quantity and positions of the conductive contact points 21 correspond to those of the conducting plates 12, such that when the power supply board 20 is inserted into the gap, the conducting plates 12 can be fixed onto the electric connector 10 by clamping or soldering, and the conducting plates 12 and the conductive contact points 21 are contacted to form an electrically conducting circuit.

The power supply board 20 further installs a plurality of designed electronic parts 22, and the power supply board 20 has a power-in connector 23 and a power-out connector 24, wherein the power-in connector 23 can be connected with a DC power of an external port (not shown in the figure), and the external DC power of this embodiment is 6~48V, and the power supply board 20 supplies the required power of the circuit board 30, and the power-out connectors 24 are connected with other electronic equipments (not shown in the figure) for supplying the required DC power, and the DC output power terminal can provide a PSON control signal (Power Supply On control signal), a PWRGOOD signal (Power Good control signal) and a DC power of 3.3, 5, +12V or 5VSB (5V Power Standby).

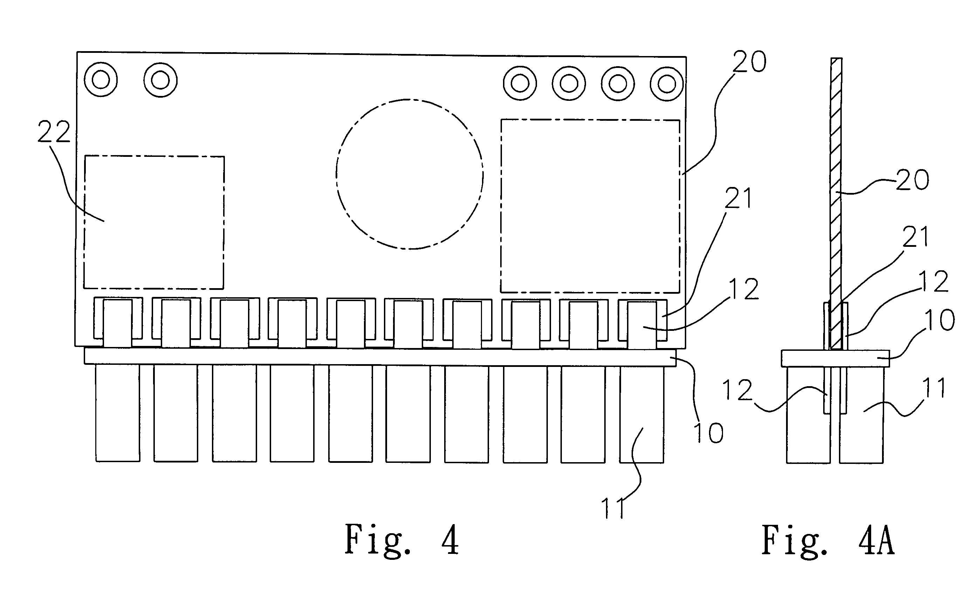

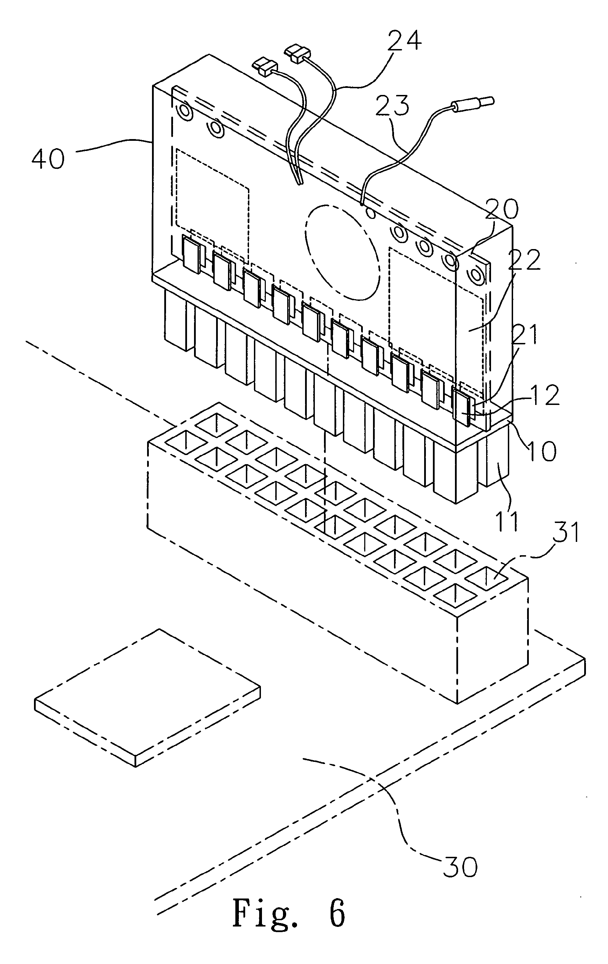

Referring to Figs. 4, 4A, 5 and 6, the power supply board 20 is inserted and fixed between the conducting plates 12, and the pins 11 of the electric connector 10 are inserted into the slots 31 of the circuit board 30, and the conducting plate 12 in the pin 11 is electrically connected to the slot 31, so that the thickness of the power supply board 20 is smaller than that of the prior art. The invention not only centralizes the conducting plate 12 from both lateral sides towards the middle to decrease the volume of the whole electric connector 10 and results in an overall smaller device, but also reduces the occurrence of a poor contact. Further, the exterior of the power supply board 20 are encapsulated by a plastic substance 40 (such as silicone and plastic) and integrated with the electric connector 10 to provide an overall simple and neat appearance of the present invention.

In summation of the above description, the present invention herein enhances the performance than the conventional structure and further complies with the patent application requirements and is submitted to the Patent and Trademark Office for review and granting of the commensurate patent rights.

While the invention is described in some detail with reference to certain illustrated embodiments, it is to be understood that there is no intent to limit the invention to those embodiments. On the contrary, the object is to cover all modifications, alternatives and equivalents falling within the spirit and scope of the invention as defined by the appended claims.

## Claims

1. A micro power supply device, inserted into slots of a circuit board, and said circuit board being fixed into an electronic system, and said device comprises:
an electric connector, having a plurality of oppositely arranged protruding conducting plates on a side of said electric connector, and said conducting plates being installed proximate to a middle position of said electric connector, and said conducting plates further having a plurality of pins on another side of said electric connector, and another end of said pins being provided for sheathing another end of said conducting plate and electrically coupling with said slot;
a power supply board, inserted between said conducting plates of said electric connector, and having a plurality of conductive contact points at a surface of said power supply board, and the quantity and positions of said conductive contact points correspond to those of said conducting plates, and said power supply board further having a power-in connector and a power-out connector, wherein said power-in connector is connected to a power of an external port, and said power supply board supplies the required power to said circuit board, and said power-out connectors are connected with other electronic equipments in an electronic system for supplying the required power;
such that said power supply board is precisely inserted between said conducting plates, and said conducting plates are centralized at the middle to reduce the volume of said whole electric connector, so as to reduce said whole device and reduce the occurrence of a poor contact.

2. The micro power supply device according to claim 1, wherein said power-in connector is connected to a DC power of an external port.

3. The micro power supply device according to claim 2, wherein said inputted DC power is 6V~48V.

4. The micro power supply device according to claim 1, wherein said power-out connector supplies a DC power.

5. The micro power supply device according to claim 4, wherein said outputted DC power is 3.3V, 5V, +12V, or 5VSB (5V Standby).

6. The micro power supply device according to claim 1, wherein said power supply board is inserted between said conducting plates and fixed by a soldering method.

7. The micro power supply device according to claim 1, wherein said power supply board is inserted between said conducting plates and fixed by a method of clamping said power supply board between said conducting plates.

8. The micro power supply device according to claim 1, wherein said power-out connector supplies a PSON control signal (Power Supply On control signal).

9. The micro power supply device according to claim 1, wherein said power-out connector supplies a PWRGOOD control signal (Power Good control signal).

10. The micro power supply device according to claim 1, wherein said power supply board is integrated with said electric connector by encapsulating the exterior of said power supply board and said electric connector with a plastic substance.
